Europäisches Patentamt

European Patent Office

Office européen des brevets

(19)

(11) Publication number: **0 370 421**

**A1**

## (12) EUROPEAN PATENT APPLICATION

(21) Application number: **89121399.3**

(22) Date of filing: **18.11.89**

(51) Int. Cl.5: **H01Q 17/00**

(30) Priority: **22.11.88 JP 295493/88**

(43) Date of publication of application:
**30.05.90 Bulletin 90/22**

(84) Designated Contracting States:
**DE FR GB NL**

(71) Applicant: **AKZO KASHIMA LIMITED**
**1, Oaza Sunayama Hasaki-machi**
**Kashima-gun Ibaraki-ken(JP)**

(72) Inventor: **Hiroshi, Ohkawa**
**c/o Akzo Kashima Limited**
**1,Oaza,Sunayama,Hasaki-**
**machi, Kashima-gun,Ibaraki-ken(JP)**

(74) Representative: **Görtz, Dr. Fuchs, Dr.**
**Luderschmidt Patentanwälte**
**Abraham-Lincoln-Strasse 7 Postfach 46 60**
**D-6200 Wiesbaden(DE)**

(54) **Electromagnetic wave absorber.**

(57) An electromagnetic wave absorber (1) for converting energy of propagated electromagnetic waves to heat energy for absorbing the electromagnetic waves is disclosed. The electromagnetic wave absorber (1) comprises a hollow taper section (2) consisting of a shell formed by plates (10) composed of a region as base material and incorporating carbon, and a stem section (3) integral with the bottom of said taper section. In the stem section (3), a plurality of electromagnetic wave absorbing layers (16a,b,c,d) composed of a resin as base material and incorporating carbon are arranged at a prescribed interval from one another. The individual electromagnetic wave absorbing layers (16a-d) increase stepwise in thickness as the layer goes away from the nearest to the leading end of the electromagnetic wave absorber (1). A great proportion of electromagnetic wave reaching the leading end of the electromagnetic wave absorber (1) proceeds into the electromagnetic wave absorber without being reflected to be captured in the stem section without being reflected. In consequence, the amount of electromagnetic wave reflected in the electromagnetic wave absorber (1) is reduced, and much electromagnetic wave is absorbed in the electromagentic wave absorber.

FIG.2

# ELECTROMAGNETIC WAVE ABSORBER

## BACKGROUND OF THE INVENTION

### 1. Field of the Invention

This invention relates to an electromagnetic wave absorber used for anechoic or semi-anechoic chambers or shield rooms.

### 2. Description of the Prior Art

Anechoic or semi-anechoic chambers are used for measuring electromagnetic wave noises generated from various electronic devices represented by computers without receiving influence of external electromagnetic waves. Such an anechoic chamber is constituted by a space covered by metal shield walls for preventing intrusion of external electromagnetic waves. In this space, an electromagnetic wave noise source and a receiving unit for measuring noise are disposed in the space for determining the state of noise generation in a state free from external electromagnetic waves.

In an ordinary anechoic chamber, electromagnetic wave absorber is applied to its shield wall inner surface. An anechoic chamber using electromagnetic wave absorber applied to it is disclosed in, for instance, Japanese Patent Laid-Open Sho 61(1986)-292,999. As the electromagnetic wave absorber is used those of resistive type. This type of electromagnetic wave absorber is of pyramid type. The sectional area of resistor is increased in relation to the progress of electromagnetic waves, and electromagnetic energy of electromagnetic waves striking the resistor is converted into thermal energy to avoid reflection of electromagnetic waves.

With this type of electromagnetic absorber the sectional area is increased progressively as one goes from the top to the bottom. It is solid, and therefore one electromagnetic wave absorber body has a rather heavy in weight. Therefore, an operation of applying the electromagnetic wave absorber to the front and rear walls, left and right walls and ceiling wall as shield wall surfaces is not so easy because of the great weight of the material.

The prior art electromagnetic wave absorber has a pyramidal shape so that its sectional area increases in relation to the progress of electromagnetic waves. This is done so because with the smaller sectional area of the surface section of the electromagnetic wave absorber the electric conductivity and dielectric constant of that section is the lower so that it is possible to avoid reflection of incident waves and the greater the electric conductivity and dielectric constant the greater is the energy loss, i.e., conversion of electromagnetic energy into thermal energy in the partient part of the absorber. However, in the above case the weight of the electromagnetic wave absorber is increased to present the above problems.

Accordingly, the inventors have conducted various experiments in order to develop electromagnetic wave absorbers, which are light in weight and can reliably absorb electromagnetic waves in a wide frequency range of 30MHz to 1 GHz in an anechoic chamber.

A plurality of electromagnetic wave absorbing plates are disposed side by side at a prescribed interval, and electromagnetic waves are passed through these plates to cause their energy loss, while suppressing their reflection by plates nearer an electromagnetic wave source and cause their great absorption by remoter plates. When the absorption of waves is increased, the reflection of waves toward the wave source in the pertinent portion is increased. However, waves returning from positions remoter from the wave source are transmitted through electromagnetic wave absorber plates even when the waves are reflected waves. The inventor further endeavored to obtain a structure which can cause energy loss and absorb waves. If there is such a structure, it will permit reliable absorption of incident waves to suppress reflection thereof without increasing the weight of the electromagnetic wave absorber.

Electromagnetic wave at various frequencies are irradiated on an electromagnetic wave absorbing plate having a certain thickness to find that waves at frequencies below 200 MHz are comparatively readily transmitted through the plate while waves at higher frequencies are comparatively difficulty transmitted to result in comparatively great loss while they are being transmitted through the plate. An experiment is also conducted with respect to waves at the above frequencies using an electromagnetic waves absorbing plate having an increased thickness to find that high frequency waves behave with respect to the increased thickness plate as though the electric conductivity and dielectric constant were increased and reflected by an increased amount by the plate surface while low frequency waves are losses by an increased amount in the plate.

## SUMMARY OF THE INVENTION

A primary object of the invention is to provide an electromagnetic wave absorber comprising a hollow taper section consisting of a pyramidal shell formed by electromagnetic wave absorbing plates containing carbon particles and a stem section provided on the bottom of the taper section and including a plurality of electromagnetic wave absorbing plates containing carbon particles, the electromagnetic wave absorbing plates having different thicknesses and arranged at a prescribed interval from one another in the stem section.

Another object of the invention is to provide an electromagnetic wave absorber, which can suppress reflection of electromagnetic waves over a frequency range from low frequencies of about 30 MHz to high frequencies of several GHz.

A further object of the invention is to provide an electromagnetic wave absorber, wherein the electromagnetic wave absorbing plates disposed in the stem section have progressively greater thicknesses as one goes away from the taper section.

A still further object of the invention is to provide an electromagnetic wave absorbing material, in which electromagnetic wave absorbing plates having the same thickness are used to form the taper section and disposed in the stem section, and different numbers of electromagnetic wave absorbing plates are provided in the stem section as different laminations arranged at a prescribed interval from one another.

A yet further object of the invention is to provide an electromagnetic wave absorber, in which the electromagnetic wave absorbing plates each have a lightweight structure having a plurality of distinct strip-like inner spaces.

In accordance with the present invention there is provided an electromagnetic wave absorber for converting energy of propagated electromagnetic waves into heat energy for absorbing the electromagnetic waves, comprising: a hollow taper section consisting of a shell formed by plates composed of a resin as base material and incorporating carbon; a stem section bounded to the bottom of the taper section; and a plurality of electromagnetic wave absorbing layers disposed internally at a prescribed interval from one another and extending in a direction substantially at right angles to the center line of the taper section, the electromagnetic wave absorbing layers consisting of plates composed of a resin as base material and incorporating carbon; the electromagnetic wave absorbing layers increasing stepwise in thickness as the layer goes away from the taper section, so that the average electric conductivity of a region in the stem section extending in the right angle direction increases stepwise as the region goes away from the taper section.

## BRIEF DESCRIPTION OF THE DRAWINGS

Fig. 1 is a perspective view showing an embodiment of the electromagnetic wave absorber according to the invention ;

Fig. 2 is a section view taken along line II-II in Fig. 1;

Fig. 3 is a fragmentary perspective view showing an electromagnetic wave absorbing plate constituting a taper section shown in Figs. 1 and 2;

Figs. 4A to 4D are fragmentary perspective views showing electromagnetic wave absorbing plates constituting a stem section of the electromagnetic wave absorber;

Fig. 5A is a fragmentory perspective is a partially cutaway view in perspective of an anechoic chamber with one electromagnetic wave absorber mounted on the inner surface of a metal wall;

Fig. 5B is a sectional view of the anechoic chamber shown in Fig. 5A;

Fig. 6 is a perspective view showing a different embodiment of the electromagnetic wave absorber according to the invention;

Fig. 7 is a perspective view showing a further embodiment of the electromagnetic wave absorber according to the invention;

Fig. 8 is a perspective view showing a further embodiment of the electromagnetic wave absorber according to the invention;

Fig. 9 is a sectional view showing a further embodiment of the electromagnetic wave absorber according to the invention;

Fig. 10 is a sectional view showing a further embodiment of the electromagnetic wave absorber according to the invention;

Fig. 11 is a sectional view showing a further embodiment of the electromagnetic wave absorber according to the invention; and

Figs. 12A and 12B are graphs showing reflection characteristic data of the electromagnetic wave absorbing material according to the invention.

## DESCRIPTION OF THE PREFERRED EMBODIMENTS

Now, an embodiment of the invention will now be described in detail.

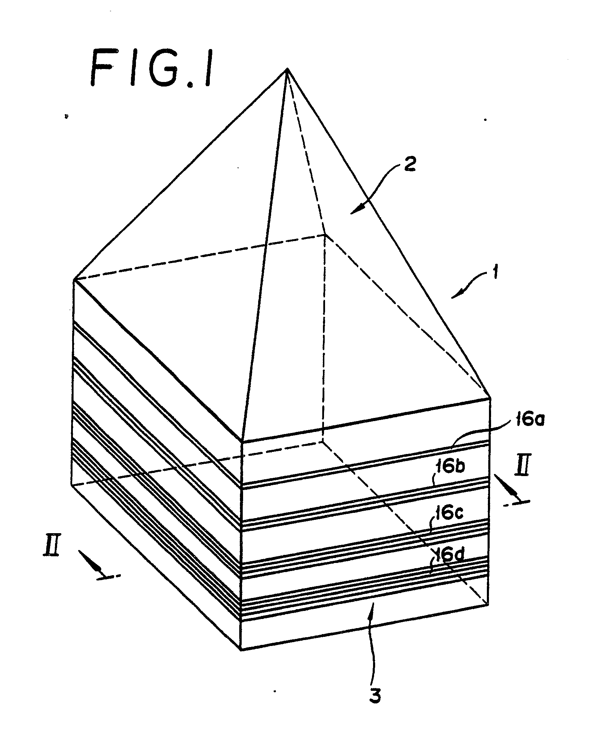

Fig. 1 shows an embodiment of electromagnetic wave absorber 1 according to the invention. The electromagnetic wave absorber 1 comprises a taper section 2 which is also called right pyramid section or cone section and a rectangular stem section 3 integral with the bottom of the taper section 2.

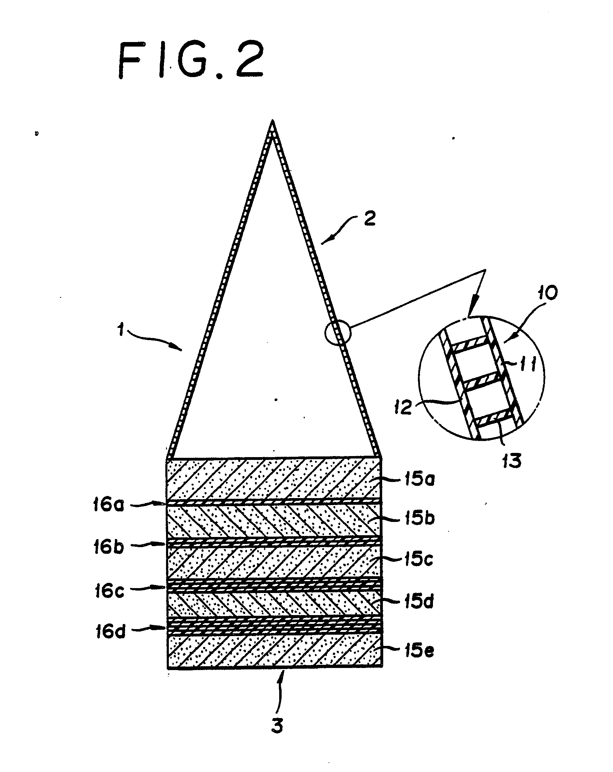

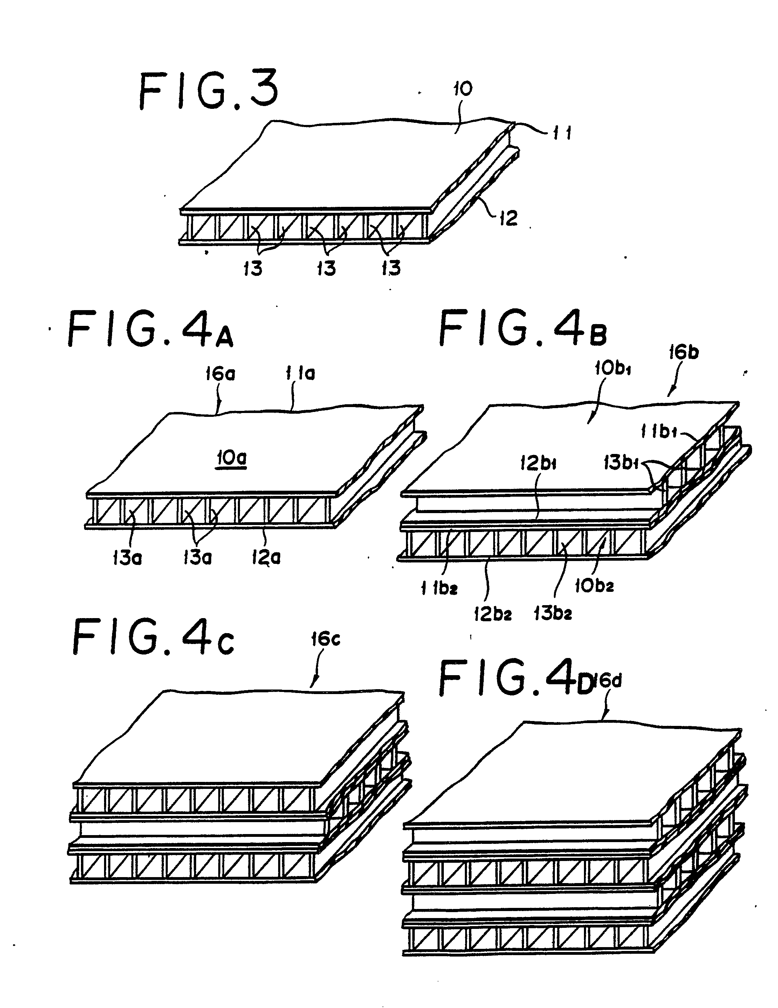

The taper section 2, as apparent from Figs 2 and 3, is hollow and consists of electromagnetic wave absorbing plates 10. The electromagnetic wave absorbing plate 10 consists of inner and outer walls 11 and 12 spaced apart by a prescribed interval and plurality of parallel connecting walls 13 extending at right angle to and connecting together inner and outer walls 11 and 12. A plurality of strip-like spaces are thus defined in the electromagnetic wave absorbing plates 10. Walls 11 to 13 are made of a material composed of polypropyrene and incorporating carbon particles, and they have a thickness of about 1 to several millimeters. They are electric conductors having a resistance of $10^3$ to $10^4$ ohms, for instance, which is determined by the amount of carbon particles incorporated. Their dielectric constant is set to a given value by adjusting the amount of carbon.

The stem section 3 includes five stationary layers 15a to 15b, which are made of a foamed resin such as foamed styrol or foamed urethane, i.e., an insulator, and form electromagnetic space or "null", and four electromagnetic wave absorbing layers 16a to 16d, which intervene between adjacent ones of stationary layers 15a to 15e and has the same structure as electromagnetic wave absorbing plates 10. With the electromagnetic wave absorbing layers inclusive of the stationary layers consisting of insulator, the average electric conductivity of a zone extending in a direction at right angle to the center axis of the electromagnetic wave absorber is increased stepwise as one goes away from the taper section 2.

The first electromagnetic wave absorbing layer 16a which is nearest to the taper section 2, as shown in Fig. 4A, consists of an electromagnetic wave absorbing plate 10a having the plate 10, consisting of upper and lower walls 11a and 12a and a plurality of connecting walls 13a connecting together walls 11a and 12a. Again it is made of a material composed of polypropyrene and incorporating carbon particles.

The second electromagnetic wave absorbing layer 16b is located to be remoter from taper section 2 than the layer 16a. As shown in Fig. 4B, it consists of two electromagnetic wave absorbing plates 10b1 and 10b2. Like electromagnetic wave absorbing plate 10a, plate 10b1 consists of upper an lower walls 11b1 and 12b1 and connecting walls 13b1 while plate 10b2 consists of upper and lower walls 11b2 and 12b2 and connecting walls 13b2. The third and fourth electromagnetic wave absorbing layers 16c and 16d, as shown in Figs. 4C and 4D, respectively consist of three and four electromagnetic wave absorbing plates same as that of the first electromagnetic wave absorbing layer. The fourth electromagnetic wave absorbing layer 16d is the final layer. The electromagnetic wave absorbing plates constituting the electromagnetic wave absorbing layers are hollow and light in weight.

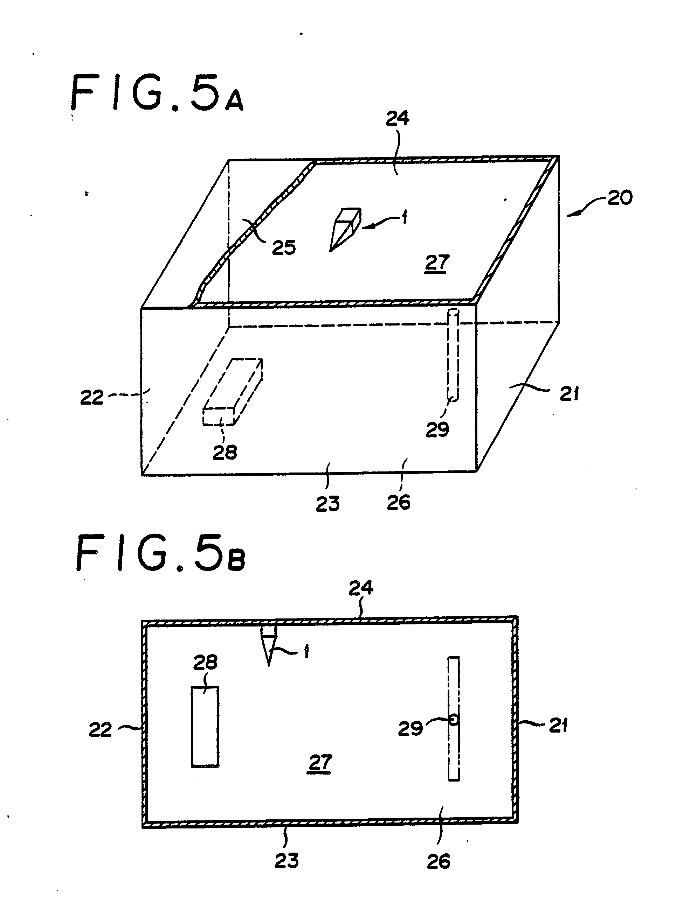

Figs. 5A and 5B show the single electromagnetic wave absorber 1 mounted in an anechoic chamber, exaggeratingly. The anechoic chamber 20 has an inner measuring space 27 which is rectangular in a horizontal plane, and defined by metal walls. i.e., side walls 21 to 24, a ceiling wall 25 and a bottom wall 26, these walls preventing intrusion of external electromagnetic waves into the space 27. Actually, anechoic chamber 20 is provided with an operator's entrance/exit and a measuring instrument entrance/exit. In Figs. 5A and 5B such entrances/exits are not shown.

In the space 27 of anechoic chamber 20, as shown in the drawings a transmitter 28 for transmitting electromagnetic waves and a receiving antenna 29 for receiving linearly polarized components of the transmitted waves are disposed. In this case the transmitter 28 transmits waves having vertically polarization components, and the receiving antenna 29 uses a rod-like linearly polarization component antenna. Where the transmitter 28 transmits horizontally polarization components to be received by the receiver 29, a horizontally extending receiving antenna 29 is disposed, as shown by phantom lines in Fig. 5B.

Irrespective of the direction of polarization component of wave transmitted from the transmitter 28, the primary reflected wave the receiving antenna 29 is reached at obtuser angles to the left and right walls 23 and 24 than to the front and rear walls 21 and 22. The obtuse the reflection angle, the greater is the amount of primary reflected waves incident on the receiving antenna 29.

However, it is through that in the case of the horizontally polarization a greater amount of wave is incident on the receiving antenna 29 after reflection by the upper and lower walls 25 and 26, while in the case of the vertical polarization a greater amount of wave is incident on antenna 29 after reflection by the left and right walls 22 and 24. It is also found that where a plurality of electromagnetic wave absorbing members like connecting walls 13 shown in Fig. 3 are arranged at a prescribed interval, the polarization component reached in parallel to the wall 13 is reflected at a greater amount, on the contrary the polarization component reached perpendicularly to it is transmitted at a greater amount.

According to the invention, electromagnetic wave absorber 1 is mounted on the inner surface of either one of walls 21 to 24 such that the connecting walls 13a of the first electromagnetic wave absorbing layer 16a are directed horizontally. Thus, vertically polarization components of waves transmitted from transmitter 28 are mainly reflected by left and right walls 23 and 24 and reach receiving antenna 29. However, a greater portion of wave is transmitted through the connecting walls 13a of the first electromagnetic wave absorbing layer 16a, and the reflection is reduced. Also, as noted above, a comparatively small amount of wave reaches receiving antenna 29 after reflection by the front and rear walls 21 and 22 because wave from the transmitter 28 is incident on walls 21 and 22 at an acute angle.

In view of the above, when it is considered to mount electromagnetic wave absorber 1 on the inner surface of the upper and lower walls 25 and 26, it is desired to mount the material 1 such that the connecting walls 13a of first electromagnetic wave absorbing layer 16a are directed in the longitudinal direction of anechoic chamber 20, i.e., the direction of line connecting transmitter 28 and receiving antenna 29. However, all the connecting walls may be directed in the same direction.

When electromagnetic wave absorber 1 according to the invention is mounted in the anechoic chamber 20 as shown in Figs. 5A and 5B, waves from transmitter 28 are incident on the taper section 2 of the electromagnetic wave absorber 1. Since the taper section 2 has inclined surfaces, less primary reflected waves therefrom directly reach the receiving antenna 29. Also, wave is readily transmitted through comparatively thin electromagnetic wave absorbing plate 10. Further, since the plate 10 is inclined, a function as if there were a thicker electromagnetic wave absorbing material than the plate 10 is provided for an incident wave parallel to the center line of electromagnetic wave absorber 1.

Wave transmitted through the taper section 2 is attenuated to be incident on the first electromagnetic wave absorbing layer 16a. The transmitted and attenuated wave is further transmitted through the subsequent layers to each fourth layer 16d. In the top portion of electromagnetic wave absorber 1, the material lying in a lateral plane transmits a comparatively large amount of wave because of the low density, thus increasing the amount of wave captured in the stem section 3. The captured wave partly emerges from the electromagnetic wave absorber 1 and reflected toward the space 27 to be further attenuated by electromagnetic wave absorbing plates, through which the wave has already been transmitted.

Particularly, electromagnetic wave absorbing plates having the same electric conductivity provides higher transmissivity to incident waves at low frequencies of about 30 to 200 MHz than to waves at higher frequencies. According to the invention, the thickness of the first to fourth layer 16a to 16d is increased by one electromagnetic wave absorbing plate for each layer toward the fourth layer 16d. Thus, the average electric conductivity is increased stepwise for region including each layer, and transmissvity is progressively reduced with low frequency waves as well. Further, it is found that since a plurality of electromagnetic wave absorbing layers are laminated alternately with stationary layers 15a to 15e as electromagnetic space rather than increasing the electric conductivity continuously, incident waves strike the electromagnetic wave absorbing layers stepwise to increase attenuation. Thus, with the anechoic chamber 20 using the electromagnetic wave absorber 1 according to the invention, it is possible to attenuate the reflected waves from the transmitter 28 greatly and thus determine the state of generation of waves under a nearly ideal condition.

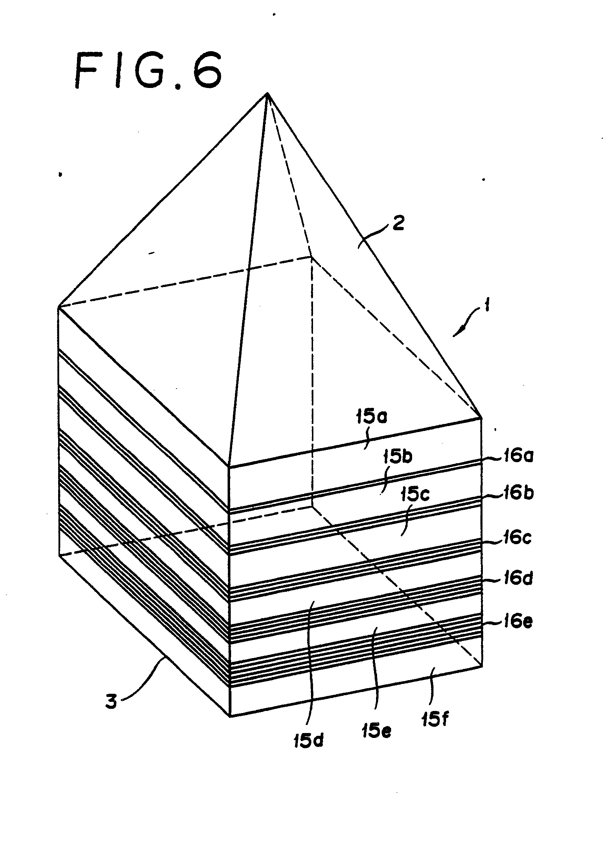

Fig. 6 shows a different embodiment of electromagnetic wave absorber 1 according to the invention. In this case, the stem section 3 has five electromagnetic wave absorbing layers 16a to 16e and six stationary layers 15a to 15f made of a resin.

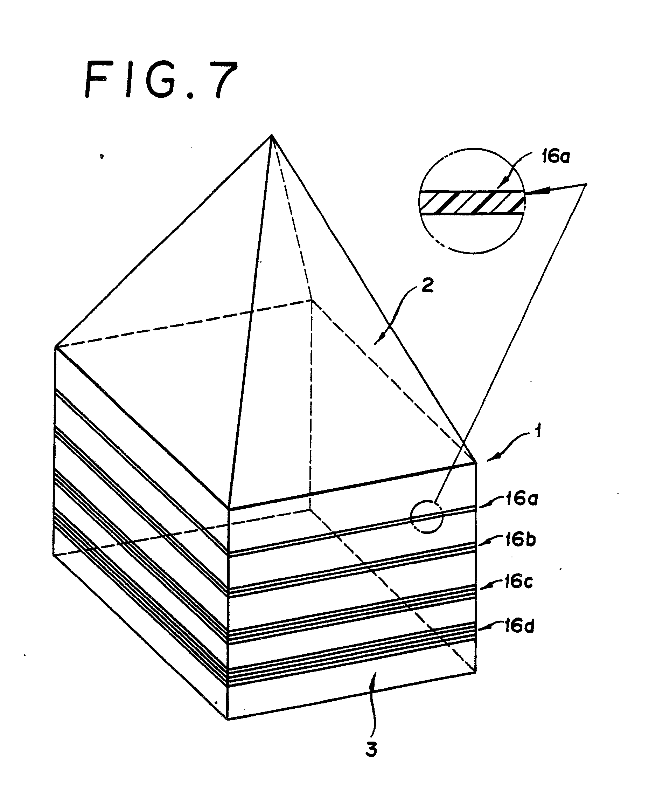

In the above embodiments each electromagnetic wave absorbing plate was hollow as shown in Figs. 3 and 4A to 4D. However, it is possible to use solid electromagnetic wave absorbing plates as shown in Fig. 7.

This structure has the same appearance as the structure shown in Figs. 1 and 2. However, first layer 16a is constituted by a single electromagnetic wave absorbing plate made of a resin containing carbon particles, and the succeeding layers increasing numbers of plates by one for each layer.

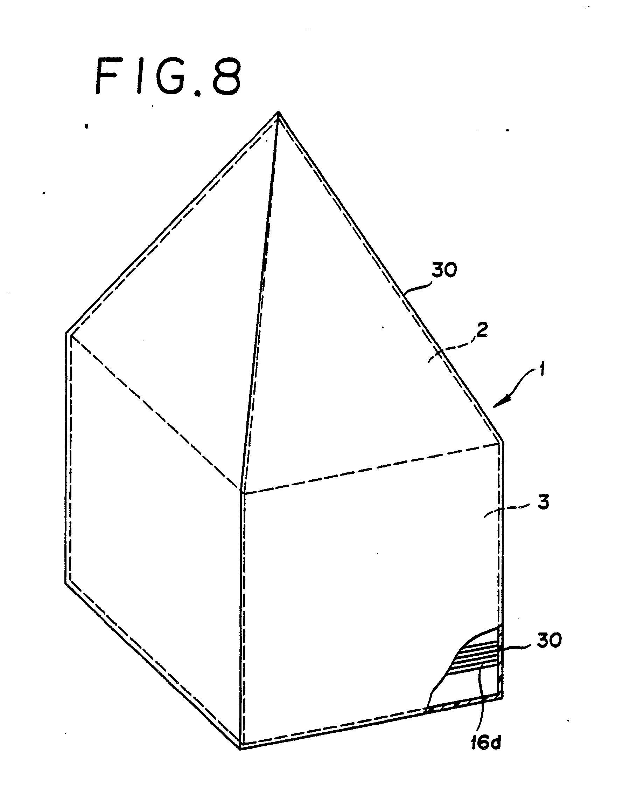

Fig. 8 shows a further embodiment of electromagnetic wave absorber according to the invention. In this case, the electromagnetic wave absorber 1 shown in Fig. 1 is covered by a cover 30 several centimeters thick. By so doing, the anesthetic appearance of each electromagnetic wave absorbing material 1 can be improved. The cover 30 desirably uses a foamed resin like the stationary layers for weight reduction. In the illustrated case, foamed polyurethane is used. Further, the cover 30 desirably contains carbon particles as noted above, and in this case electromagnetic wave absorption effect can be obtained with the cover 30 itself as well.

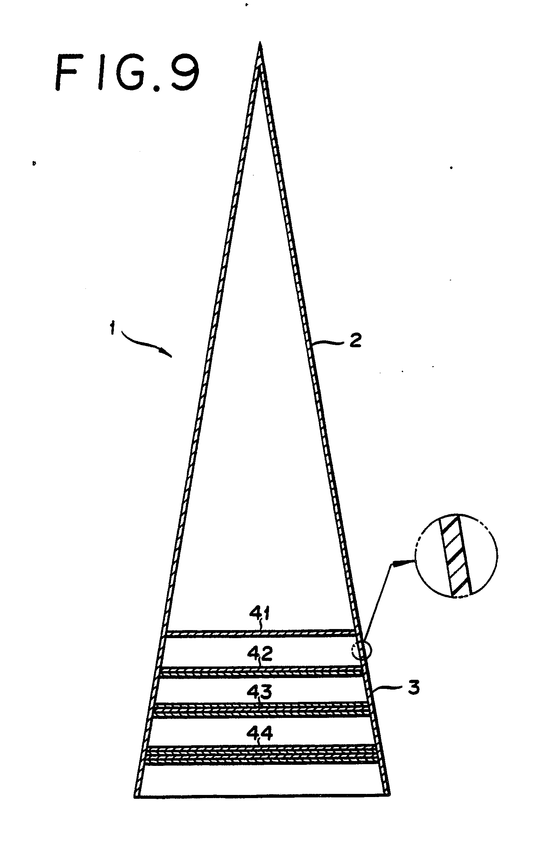

Fig. 9 is a sectional view showing a further embodiment of the electromagnetic wave absorber according to the invention. In this electromagnetic wave absorber 1, the stem section 3 integral with the bottom of the taper section 2 has a shape as an extension of the taper of the taper section 2. Thus, the outer walls of the stem section 3 are extensions of the walls of the taper section 2. These walls may be constituted by hollow electromagnetic wave absorbing plates as those shown in Fig. 2. In the illustrated case, however, they are constituted by solid electromagnetic wave absorbing materials.

Further, in the structure shown in Fig. 9, the stem section 3 has four electromagnetic wave absorbing layers 41 to 44 spaced apart from one another, i.e., defining a space between adjacent ones of these layers. The first electromagnetic wave absorbing layer 41 is constituted by a single electromagnetic wave absorbing plate, and the individual layers have increasing numbers of layers by one for each other toward the fourth layer 44.

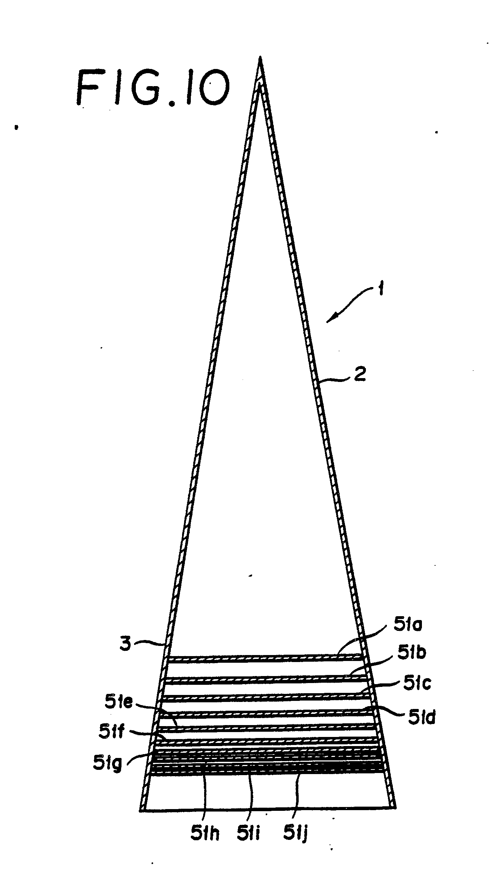

Fig. 10 shows a further embodiment of electromagnetic wave absorber according to the invention. The basic structure in this case is almost the same as the electromagnetic wave absorber shown in Fig. 9. In this case, however, ten electromagnetic wave absorbing plates 51a to 51j are incorporated in the stem section 3. These plates are spaced apart from one another such that the distance between adjacent ones of them is reduced as one goes away from the taper section 2.

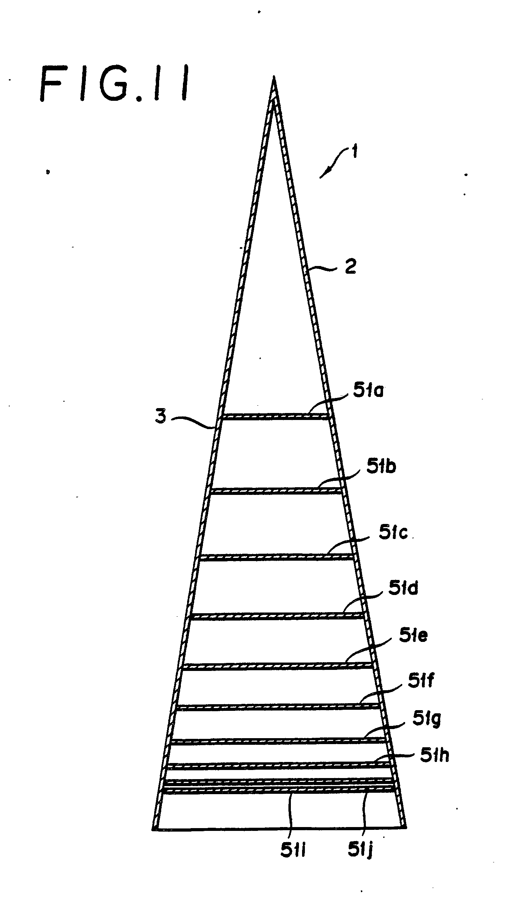

Fig. 11 shows a modification of electromagnetic wave absorber shown in Fig. 10. In this modification, the same number of electromagnetic wave absorbing plates 51a to 51j are used. The modification is different from the structure shown in Fig. 10 in that the steam section 3 has a greater height than the height of the taper section 2.

In each of the above embodiments, as resin to which carbon is added may be used various resins such as vinyl chloride as well as polypropyrene noted above.

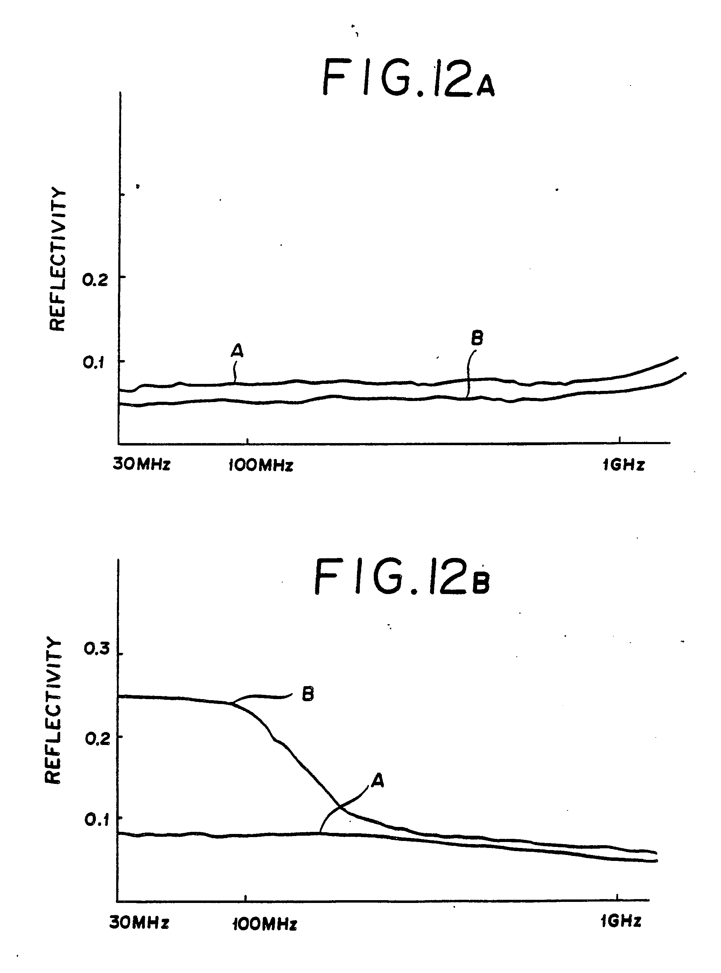

Figs. 12A and 12B are graphs showing measurement date concerning the electromagnetic wave absorbing effect according to the invention. Fig. 12A shows measurement data concerning the reflectivity of electromagnetic wave absorber only, without use of metal plates corresponding to wall members constituting an anechoic chamber. Data labeled A is of the reflectivity of an electromagnetic wave absorber including taper section 2 also called cone section and stem section 3 as showing in Fig. 1, and data labeled B is of the reflectivity of an electromagnetic wave absorber consisting of taper section 2 only.

Fig. 12B shows data obtained by mounting electromagnetic wave absorber on metal reflecting plates corresponding to wall members constituting an anechoic chamber, irradiating the electromagnetic wave absorber with wave and measuring the reflectivity of the electramagnetic wave absorber. In the Figure, like Fig. 12A, date labeled A is obtained with the electromagnetic wave absorber including the taper section 2 and stem section 3, and data labeled B is obtained with the electromagnetic wave absorber consisting of taper section 2 only. As is obvious from these graphs, according to the invention, the reflectively can obviously be reduced over a wide frequency range from low to high frequencies.

While the taper section in the illustrated embodiments is pyramidal, it is possible to use a conical taper section as well.

According to the invention, incident high frequency electromagnetic waves are captured in the stem section with their reflection suppressed by electromagnetic wave absorbing layers near the taper section. On the other hand, incident low frequency waves are attenuated till reaching the final layer, which has increased electric conductivity, although they intrude up to a layer near the final layer.

Further, waves reflected by each electromagnetic wave absorbing layer are attenuated in each region, through which they have been transmitted, thus greatly reducing the amount of wave returning to the space in the anechoic chamber after reflection.

Further, since the taper section of the electromagnetic wave absorber is constituted by electromagnetic wave absorbing material which is hollow and light in weight, the electromagnetic wave absorber can be readily mounted in the anechoic chamber. In addition, the electromagnetic wave absorber can reliably capture waves particularly in a low frequency region and eliminate reflection.

## Claims

1. An electromagnetic wave absorber for converting energy of propagated electromagnetic waves into heat energy for absorbing the electromagnetic waves, comprising:
a hollow taper section consisting of a shell formed by plates composed of a resin as base material and incorporating carbon;
a stem section bounded to the bottom of said taper section; and
a plurality of electromagnetic wave absorbing layers disposed internally at a prescribed interval from one another and extending in a direction substantially at right angles to the center line of said taper section, said electromagnetic wave absorbing layers consisting of plates composed of a resin as base material and incorporating carbon;
said electromagnetic wave absorbing layers increasing stepwise in thickness as the layer goes away from said taper section, so that the average electric conductivity of a region in said stem section extending in said right angle direction increases stepwise as the region goes away from said taper section.

2. The electromagnetic wave absorber according to claim 1, wherein said stem section consists of an alternate lamination of electromagnetic wave absorbing layers consisting of electromagnetic wave absorbing plates composed of a resin as base material and incorporating carbon and stationary layers composed of an insulating material and constituting electromagnetic space.

3. The electromagnetic wave absorber according to one of claims 1 and 2, wherein said electromagnetic wave absorbing layers consist of different numbers of electromagnetic wave absorbing pates having the same thickness.

4. The electromagnetic wave absorber according to one of claims 1 and 2, wherein said electromagnetic wave absorbing layers respectively consist of a sheet of electromagnetic wave absorbing plates having different thickness.

5. The electromagnetic wave absorber according to one of claims 1 and 2, wherein said shell of said taper section and said electromagnetic wave absorbing layers in said stem section are composed of a resin as base material and incorporating carbon and constituted by hollow walls each formed by two wall members and a plurality of parallel connecting members extending between and connecting together said wall members.

6. The electromagnetic wave absorber according to one of claims 1 and 2, wherein said shell of said taper section and said electromagnetic wave absorbing layers in said stem section are constituted by solid plates composed of a resin as base material and incorporating carbon.

7. The electromagnetic wave absorber according to one of claims 1 and 2, wherein electromagnetic wave absorbing plates having the same thickness are disposed in said stem section at smaller intervals as one goes away from said taper section.

8. The electromagnetic wave absorber according to claim 1, wherein the outer surfaces of said taper section and stem section are covered by a cover.

9. An electromagnetic wave absorber for converting energy of propagated electromagnetic waves into heat energy to absorb the electromagnetic waves, comprising:
a hollow tapering body consisting of a shell formed by plates composed of a resin as basic material and incorporating carbon; and
a plurality of electromagnetic wave absorbing layers disposed in a stem portion of said tapering body at a prescribed interval from one another and substantially at right angles to the center line of said tapering body, said electromagnetic wave absorbing layers consisting of respective plates composed of a resin as base material and incorporating carbon;
said electromagnetic wave absorbing layers increasing stepwise in thickness as the layer goes away from the nearest to the leading end of said tapering body, so that the average electric conductivity of a region in said stem section extending in said right angle direction increases stepwise as the region goes away from the leading end of said tapering body.

10. The electromagnetic wave absorber according to claim 9, wherein in said stem portion is provided an alternate lamination of electromagnetic wave absorbing layers consisting of electromagnetic wave absorbing plates composed of a resin as base material and incorporating carbon, and stationary layers composed of an insulating material and constituting electromagnetic space.

11. The electromagnetic wave absorber according to one of claims 9 and 10, wherein said electromagnetic wave absorbing layers consist of different numbers of electromagnetic wave absorbing plates having the same thickness.

12. The electromagnetic wave absorber according to one of claims 9 and 10, wherein said electromagnetic wave absorbing layers respectively consist of a sheet of electromagnetic wave absorbing plate having different thickness.

13. The electromagnetic wave absorber according to one of claims 9 and 10, wherein said shell of said tapering body and said electromagnetic wave absorbing layers in said stem portion are composed of a resin as base material and incorporating carbon and constituted by hollow walls each formed by two wall members and a plurality of parallel connecting members extending between and connecting together said wall members.

14. The electromagnetic wave absorber according to one of claims 9 and 10, wherein said shell of said tapering portion and said electromagnetic wave absorbing layers in said stem portion are constituted by solid plates composed of a resin as base material and incorporating carbon.

15. The electromagnetic wave absorber according to one of claims 9 and 10, wherein electromagnetic wave absorbing plates having the same thickness are disposed in said stem portion at smaller intervals as one goes away from the top of said tapering body.

16. The electromagnetic wave absorber according to claim 9, wherein said tapering body is covered by a cover.

17. An anechoic chamber haivng a floor wall, an anterior and a posterior wall, a lefthand and a righthand wall, and ceiling wall, and a space for accommodation defined by said walls, and incorporating in said space for accommodation a transmission source for radiation of waves and a receiving antenna for receiving the linearly polarization component of said waves radiated by said transmission source, comprising:
a plurality of electromagnetic wave absorbers mounted at least on said front and rear walls, right and left walls and ceiling wall;

each said electromagnetic wave absorber comprising:

a hollow taper section consisting of a shell formed by plates composed of a resin as base material and incorporating carbon; and

a stem section bounded to the bottom of said taper section and including a plurality of electromagnetic wave absorbing layer disposed internally at a prescribed interval from one another and extending in a direction substantially at right angles to the center line of said taper section, said electromagnetic wave absorbing layers consisting of plates composed of a resin as base material and incorporating carbon;

said electromagnetic wave absorbing layers increasing stepwise in thickness as the layer goes away from said space, so that the average electric conductivity of a region in said stem section extending in said right angle direction increases stepwise as the region goes from said space.

18. An anechoic chamber haivng a floor wall, an anterior and a posterior wall, a lefthand and a righthand wall, and ceiling wall, and a space for accommodation defined by said walls, and incorporating in said space for accommodation a transmission source for radiation of waves and a receiving antenna for receiving the linearly polarization component of said waves radiated by said transmission source, comprising:

a plurality of electromagnetic wave absorbers mounted at least on said front sand rear walls, right and left walls and ceiling wall;

each said electromagnetic wave absorber comprising:

a hollow tapering body consisting of a shell formed by plates composed of a resin as basic material and incorporating carbon; and

a plurality of electromagnetic wave absorbing layers disposed in a stem portion of said tapering body at a prescribed interval from one another and substantially at right angles to the center line of said tapering body, said electromagnetic wave absorbing layers consisting of respective plates composed of a resin as base material and incorporating carbon;

said electromagnetic wave absorbing layers increasing stepwise in thickness as the layer goes away from said space, so that the average electric conductivity of a region in said stem section extending in said right angle direction increases stepwise as the ragion goes away from said space.

FIG.1

# FIG.2

# FIG.3

# FIG.4A

# FIG.4B

# FIG.4c

# FIG.4D

# FIG.5A

# FIG.5B

# FIG.6

# FIG.7

# FIG.8

FIG.9

1

2

41

42

43

44

3

FIG.10

# FIG.11

1

2

3

51a

51b

51c

51d

51e

51f

51g

51h

51i    51j

FIG.12A

FIG.12B

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | US-A-3 234 549 (McMILLAN) <br> * figures 1,5,6; column 5, lines 40-62 * | 1-4,7,9 -12,15 | H 01 Q 17/00 |
| A | ELECTRONICS AND COMMUNICATIONS IN JAPAN vol. 60 B, no. 7, pages 64-71, 1977; TAKASHIMA et al.: "A design method of electromagnetic absorbing walls with resistive sheets" * figures 1,2; paragraph 2.1 * | 5,6,14, 15 | |
| A | US-A-4 381 510 (WREN) <br> * figure 3, column 2, lines 43-63 * | 5,6,14, 15 | |
| A | US-A-4 170 010 (REED) <br> * figure 5, column 5, lines 57-68 * | 5,6,14, 15 | |
| A | FR-A-2 610 780 (RHEINHOLD & MAHLA GMBH) <br> * figure 1, page 4, lines 2-26 * | 17,18 | |
| A | US-A-3 836 967 (WRIGHT) <br> * figures, 1,2, column 5, lines 8-22 * | 1,9 | TECHNICAL FIELDS SEARCHED (Int. Cl.5) <br><br> H 01 Q <br> G 01 R <br> H 05 K |

The present search report has been drawn up for all claims

| Place of search | Date of completion of the search | Examiner |
|---|---|---|
| BERLIN | 17-01-1990 | DANIELIDIS S |

EPO FORM 1503 03.82 (P0401)